# EUROPÄISCHE PATENTSCHRIFT

(11) **EP 0 716 730 B1**
(45) Veröffentlichungstag und Bekanntmachung des Hinweises auf die Patenterteilung: **22.11.2006**
(21) Anmeldenummer: 95921705.0
(22) Anmeldetag: 20.06.1995
(51) Int. Cl.: G01D 11/10, G05B 19/4061

(54) **VERFAHREN ZUR VERRINGERUNG DER STÄRKE EINER UNKONTROLLIERTEN ZEIGERBEWEGUNG**
METHOD OF REDUCING THE MAGNITUDE OF AN UNCONTROLLED INSTRUMENT-POINTER MOVEMENT
PROCEDE PERMETTANT DE REDUIRE L'AMPLITUDE DU MOUVEMENT INCONTROLE D'UN INDICATEUR

(30) Priorität: 01.07.1994 DE 4423119
(43) Veröffentlichungstag der Anmeldung: 19.06.1996
(73) Patentinhaber: ROBERT BOSCH GMBH, 70442 Stuttgart (DE)
(72) Erfinder: HOFFSOMMER, Klaus, D-74321 Bietigheim-Bissingen (DE); STEGER, Roland, D-73733 Weil im Schönbuch (DE); HERZOG, Bernhard, D-70619 Stuttgart (DE)
(86) Internationale Anmeldenummer: PCT/DE1995/000790
(87) Internationale Veröffentlichungsnummer: WO 1996/001412

(56) Entgegenhaltungen:
- EP-A- 0 403 691
- DE-A- 3 923 174
- GB-A- 2 270 567

## Beschreibung

### Stand der Technik

Die Erfindung geht aus von einem verfahren zur Verringerung der Stärke einer unkontrollierten Zeigerbewegung nach dem Oberbegriff des Hauptanspruchs. Aus dem Aufsatz "Der Schrittmotor und seine Schrittdauer", Feinwerktechnik & Meßtechnik 99 (1991) 7 - 8, Seiten 327 bis 332, von Klaus Mayer ist ein Schrittmotor bekannt, der einen auf einer Motorachse angeordneten permanentmagnetischen Rotor aufweist, der sich innerhalb des rotierenden Magnetfeldes zweier Spulensysteme dreht. Montiert man auf der Achse des Rotors einen Zeiger, so ist es möglich durch die Ansteuerung des Schrittmotors einen bestimmten Drehwinkel einzustellen und den Drehwinkel mittels des Zeigers über einer Skalenscheibe anzuzeigen. Solche Systeme können z.B. für die Anzeige der Drehzahl, der Geschwindigkeit und anderer fahrzeugspezifischer Informationen in einem Kraftfahrzeugkombinationsinstrument eingesetzt werden. Es ist dabei üblich, am unteren Ende der Skala einen Anschlagstift als mechanischen Anschlag für den Zeiger vorzusehen, und insbesondere unmittelbar nach dem Einschalten des Schrittmotors, den Zeiger gegen diesen Anschlag zu fahren, um eine definierte Anfangsposition für den Rotor des Schrittmotors zu erhalten. Bei bisher üblichen Schrittmotoren tritt häufig das Problem auf, daß sich das System aus Zeiger und Schrittmotor, wobei zwischen dem Zeiger und dem Rotor auch ein Übersetzungsgetriebe angeordnet sein kann, mechanisch verspannt ist, weil die mechanischen Komponenten beim Andrücken gegen den Anschlag durch das Rotormoment elastisch deformiert werden. Die Ursache für solche Deformationen liegt dabei vor allem in der Elastizität des Zeigers und im mechanischen Spiel des Übersetzungsgetriebes. Wird nach dem Anfahren des Anschlags der Schrittmotor abgeschaltet, so kommt es dann häufig vor, dass sich die Verspannung des Systems schlagartig löst, so dass der Zeiger vom Anschlag wegspringt. Durch das unkontrollierte Abspringen des Zeigers vom Anschlag können Anzeigefehler verursacht werden. Zum anderen wird es meist von einem Fahrzeuglenker subjektiv als unangenehm empfunden, wenn der Zeiger plötzlich vom Anschlag wegspringt.
Aus der EP 0 403 691 A1 ist ein Verfahren zur Erkennung einer vorbestimmten Zeigerstellung einer Anzeigeeinrichtung bekannt. Hierbei wird detektiert, wenn der Zeiger einen Anschlag erreicht, beispielsweise indem überprüft wird, ob sich der Zeiger in Folge eines auf ihn wirkenden Drehmomentes tatsächlich gedreht hat. Wird das Erreichen des Anschlags erfasst, so wird ein Signalgenerator zur Steuerung des Zeigerrotors abgeschaltet, so dass der Rotor nicht weiter von einem Feld belastet wird, das den Zeiger gegen den Anschlag dreht.

### Vorteile der Erfindung

Das erfindungsgemäße Verfahren mit den kennzeichnenden Merkmalen des Anspruchs 1 hat demgegenüber den Vorteil, dass die Stärke einer solchen unkontrollierten Zeigerbewegung verringert wird. Unter der Stärke soll dabei der zu erwartende Drehwinkel des Zeigers bei einem Abspringen vom mechanischen Anschlag verstanden werden. Dadurch entsteht der Vorteil, dass sich der vom Schrittmotor angetriebene Zeiger auch nach einem Abschaltvorgang auf einer exakter definierten Position befindet, wodurch die Genauigkeit der Anzeige und damit der Ablesbarkeit verbessert wird. Außerdem wird das subjektive Empfinden der Zeigerbewegung bei der ablesenden Person verbessert.

Bei der Verringerung der Feldstärke besteht der weitere Vorteil, dass das Verfahren zur Verringerung der Stärke einer unkontrollierten Zeigerbewegung aufgrund der Absenkung der magnetischen Feldstärke der Ansteuerspulen besonders einfach und kostengünstig realisierbar ist.

Das Wegbewegen des Zeigers hat den Vorteil, daß aufgrund der gesteuerten Drehbewegung des Zeigers vom Anschlag weg keine freie Drehung des Rotors um mehr als den minimalen Schrittwinkel erfolgen kann, wodurch ein besonders ruhiges Drehverhalten des Rotors und somit des Zeigers resultiert.

Das erneute Einschalten nach dem Abschalten hat den Vorteil, daß aus dem Prinzip des wechselweisen Ein- und Abschaltens eine besonders einfache Ansteuerung des Schrittmotors resultiert, mittels der ein kontrolliertes Abfangen des dem Zeigerdrehmoment folgenden Rotors zur Verringerung der Stärke der unkontrollierten Zeigerbewegung erreichbar ist.

Durch die in den Unteransprüchen aufgeführten Maßnahmen sind vorteilhafte Weiterbildungen und Verbesserungen des im Anspruch 1 angegebenen Verfahrens möglich.

Durch ein kontinuierliches Absenken der Feldstärke des Magnetfelds der Ansteuerspulen wird ein sehr gleichmäßiges Rotorverhalten erzeugt und somit ein äußerst gleichmäßiges Entspannen des auf den Zeiger wirkenden Drehmoments erreicht, da der Rotor sich während des Verfahrens besonders ruckfrei bewegt.

Ebenso vorteilhaft ist es, die Feldstärke in diskreten Stufen auf einen niedrigeren Wert abzusenken, da sich durch die Diskretisierung der einzelnen zu erzielenden Feldstärkenwerte die Ansteuerung der Spulen des Schrittmotors vereinfacht.

Senkt man die Feldstärke langsamer ab als die Dauer der mechanischen Zeitkonstante des Schrittmotors, so dreht sich der Rotor des Schrittmotors, zwischen dem Zeitpunkt, bei dem das Rotormoment gerade unter das Zeigermoment absinkt und dem Zeitpunkt, zu dem das Magnetfeld der Ansteuerspulen den sich drehenden Rotor wieder in eine stabile Position zwingt, nur um weniger als eine ganze Umdrehung, bevor der Rotor vom Magnetfeld der Ansteuerspulen wieder aufgefangen wird. Das bedeutet, daß die maximale Drehgeschwindigkeit des Rotors begrenzt wird, wodurch der Zeiger so wenig wie möglich beschleunigt. Dadurch wird der Grad des Abhebens des Zeigers vom Anschlag minimiert.

Das Absenken der Feldstärke mittels Verringerung der Ansteuersspannung der Ansteuerwicklungen des Schrittmotors stellt ein besonders einfaches und kostengünstig realisierbares Verfahren zur Reduktion der Feldstärke dar.

Ebenso einfach ist es, die Pulsweite eines den Ansteuerwicklungen vorgeschalteten Pulsweitenmodulators zu verringern, da die Ansteuerung des Pulsweitenmodulators auch durch digitale Signale erfolgen kann und weil bei einer räumlichen Trennung des Pulsweitenmodulators vom Schrittmotor der Pulsweitenmodulator üblicherweise mit weniger Aufwand mit einer Vorrichtung zur Durchführung des Verfahrens ausgestattet werden kann als der Schrittmotor.

Eine besonders vorteilhafte, weil kostensparende und einfache Realisierung der Verringerung der Ansteuerspannung entsteht durch Veränderung des Elementwerts wenigstens einer steuerbaren Impedanz einer den Ansteuerwicklungen vorgeschalteten Impedanzschaltung.

Verringert man die Versorgungsspannung eines dem Schrittmotor vorgeschalteten Schrittmotortreibers, so erhält man den Vorteil, daß die zur Verringerung der Versorgungsspannung vorgesehene Schaltung direkt am räumlich meist günstiger gelegenen Schrittmotortreiber angeordnet werden kann. Außerdem ist eine Anordnung zur Verringerung der Versorgungsspannung realisierbar, ohne eine Änderung an der Schaltung des Schrittmotortreibers selbst vorzunehmen oder Einfluß auf die Funktionsweise des Schrittmotortreibers oder einer anderen dem Schrittmotor vorgeschalteten Baugruppe, beispielsweise des Pulsweitenmodulators auszuüben.

Durch das Auslesen des Ausgleichsdrehwinkels aus einem Speichermedium entsteht der Vorteil, daß für verschiedene Schrittmotoren und verschiedene mechanische Elastizitäten von Zeiger, Getriebe etc. sowie für verschiedene die Elastizitäten beeinflussende Umgebungsbedingungen der jeweils optimale Ausgleichsdrehwinkel durch einfaches Ändern des Speicherinhalts des Speichermediums einstellbar ist.

Die Wahl einer niedrigen Drehgeschwindigkeit für die Wegbewegung des Zeigers vom Anschlag dient in vorteilhafter Weise dazu, ein für die ablesende Person subjektiv angenehmes Zeigerverhalten zu erzeugen, da eine langsame Zeigerbewegung unauffälliger wirkt, als eine schnelle Zeigerbewegung.

Eine Reduktion der magnetischen Feldstärke während der Drehbewegung um den Ausgleichsdrehwinkel verringert den für eine vollständige Entspannung des mechanisch verspannten Systems nötigen Ausgleichsdrehwinkel, wodurch sich der Abschaltprozeß verkürzt. Das Reduzieren der Feldstärke des Magnetfeldes der Ansteuerspulen zwischen dem Wegbewegen des Zeigers und dem Abschalten des Schrittmotors dient in vorteilhafter Weise zur Verringerung der Stärke einer unkontrollierten Zeigerbewegung für dem Fall, wenn der Ausgleichsdrehwinkel zu klein gewählt wurde.

Das Vergrößern der Abschaltzeitspannungen bietet den Vorteil, daß, da sich die Zeigerdrehgeschwindigkeit und damit auch die Rotordrehgeschwindigkeit aufgrund der Verringerung des Zeigermoments bei sich entspannendem System verringert, mehr Zeit für eine Rotorbewegung vorhanden ist, so daß durch die Verlängerung der Abschaltzeitspanne sichergestellt ist, daß sich der Rotor trotz verminderter Drehgeschwindigkeit innerhalb der Abschaltzeitspanne um wenigstens eine halbe Rotorumdrehung in Richtung des Zeigermoments bewegt, so daß der Rotor beim Wiedereinschalten in eine stabile Position gezwungen wird, bei der ein niedrigeres Zeigermoment auftritt.

Die Vorschrift, die kürzeste Abschaltzeitspanne kleiner zu wählen als die kürzestmögliche Zeitspanne in der sich der Rotor des Schrittmotors um eine ganze Umdrehung weiterbewegt und daß die längste Abschaltzeitspanne kleiner gewählt wird als die längstmögliche Zeitspanne in der sich der Rotor des Schrittmotors um eine ganze Umdrehung weiterbewegt, führt zu dem Vorteil, daß sich der Rotor während der Abschaltzeitspanne um weniger als eine Rotorumdrehung weiterbewegt, wodurch die dabei auftretende maximale Rotordrehgeschwindigkeit begrenzt wird.

Es erweist sich zudem als vorteilhaft, wenn die Summe aus Einschaltzeitspanne und der vorhergehenden Abschaltzeitspanne größer gewählt wird als die Zeitspanne, in der sich der Rotor des Schrittmotors in diesem Zeitraum um eine ganze Umdrehung weiterbewegt, da dadurch der Roror nach der Drehbewegung während der Abschaltzeitspanne während der Einschaltzeitspanne so stark abgebremst wird, daß für die nächste Drehbewegung auch das Trägheitsmoment des Rotors zu überwinden ist, wodurch die maximale Drehgeschwindigkeit des Rotors gleichfalls verringert wird.

### Zeichnung

Ausführungsbeispiele der Erfindung sind in der Zeichnung dargestellt und in der nachfolgenden Beschreibung näher erläutert.

Es zeigen:
Figur 1 einen Schrittmotor mit Zeiger,
Figur 2 den allgemeinen Verlauf der Ansteuerspannungen mit einer kontinuierlichen Absenkung vor dem Abschalten,
Figur 3 den allgemeinen Verlauf der Ansteuerspannungen mit mehrmaligem Ein- und Abschalten,
Figur 4 den allgemeinen Verlauf des Drehwinkels mit einer Bewegung um einen Ausgleichsdrehwinkel vor dem Abschalten,
Figur 5 eine Ansteuerschaltung für einen Schrittmotor,
Figur 6 eine Impedanzschaltung zur Ansteuerung einer Ansteuerspule,
Figur 7 ein Beispiel für den Verlauf der Ansteuerspannungen mit mehrmaligem Ein- und Abschalten,
Figur 8 den Verlauf des Drehwinkels für den in Figur 7 dargestellten Verlauf der Ansteuerspannungen,
Figur 9 die stabilen Positionen des Zeigermoments und des Rotormoments für den in Figur 7 dargestellten Verlauf der Ansteuerspannungen,
Figur 10 ein Beispiel für den Verlauf der Feldrichtungen des Magnetfelds der Ansteuerspulen bei Bewegung des Rotors um einen Ausgleichsdrehwinkel,
Figur 11 den Verlauf des Drehwinkels für den in Figur 10 dargestellten Verlauf der Feldrichtungen des Magnetfelds der Ansteuerspulen,
Figur 12 den Verlauf des Rotormoments für den in Figur 10 dargestellten Verlauf der Feldrichtungen des Magnetfelds der Ansteuerspulen,
Figur 13 den Verlauf des Zeigermoments für den in Figur 10 dargestellten Verlauf der Feldrichtungen des Magnetfelds der Ansteuerspulen,
Figur 14 ein Beispiel für die stabilen und labilen Positionen des Zeigermoments und des Rotormoments bei kontinuierlicher Absenkung der Ansteuerspannungen,
Figur 15 den Verlauf der Ansteuerspannungen und des Zeigermoments für die in Figur 14 dargestellten stabilen und labilen Positionen des Zeigermoments und des Rotormoments, Figur 16 den Verlauf des Drehwinkels für die in Figur 14 dargestellten stabilen und labilen Positionen des Zeigermoments und des Rotormoments.

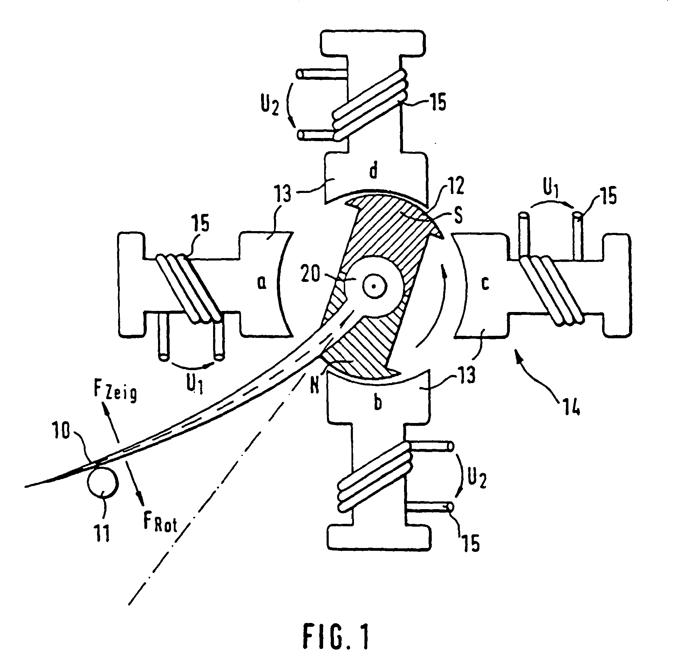

Die Figur 1 zeigt die Anordnung eines Schrittmotors 14. Der Schrittmotor 14 weist vier Spulenkerne 13 auf, die auf einer ersten Kreislinie und gegeneinander je um 90 Grad versetzt angeordnet sind. Die Spulenkerne 13 weisen je eine Ansteuerspule 15 auf. Die Enden der Spulenkerne 13 liegen jeweils paarweise einander gegenüber und weisen an den einander zugekehrten Stirnseiten je eine konkave Einbuchtung auf, wobei die konkaven Einbuchtungen der vier Spulenkerne 13 sich zu einer zur ersten Kreislinie konzentrischen weiteren Kreislinie ergänzen. Im Mittelpunkt dieser beiden Kreislinien ist drehbar um den im Mittelpunkt liegenden Schnittpunkt seiner Symmetrieachsen ein in etwa quaderförmiger Rotor 12 gelagert, der an seinen Enden konvexe Ausbuchtungen aufweist, wobei die Kreislinie der konvexen Ausbuchtungen wiederum konzentrisch zum Mittelpunkt ist und wobei der Radius der konvexen Ausbuchtungen in etwa gleich dem Radius der konkaven Einbuchtung der Spulenkerne 13 ist. Der Rotor 12 ist permanentmagnetisch ausgebildet und weist einen magnetischen Südpol und einen magnetischen Nordpol auf. Die Grenzlinie zwischen magnetischem Südpol und magnetischem Nordpol verläuft entlang der kürzesten Symmetrieachse des Rotors 12, so daß der magnetische Südpol an einem Ende des Rotors 12 und der magnetischen Nordpol am anderen Ende des Rotors 12 liegt. Auf einer Welle 20, die durch die Drehachse des Rotors 12 läuft und mit diesem drehfest verbunden ist, ist ein Zeiger 10 angeordnet. Der Zeiger 10 stößt bei einer Bewegung entgegen dem Uhrzeigersinn gegen einen mechanischen Anschlag 11. An zwei einander gegenüberliegende Ansteuerspulen 15 ist eine erste Ansteuerspannung U₁ und an das zweite Paar einander gegenüber liegender Ansteuerspulen 15 eine zweite Ansteuerspannung U₂ anlegbar. Die Spulenkerne 13 sind zudem jeweils mit einem Kennbuchstaben "a", "b", "c", "d" gekennzeichnet.

Durch Anlegen der Ansteuerspannungen U₁, U₂ an jeweils ein oder beide Paare von einander gegenüber liegenden Ansteuerspulen 15 ist im Bereich innerhalb der weiteren Kreislinie ein Magnetfeld erzeugbar, welches auf den Rotor 12 ein Drehmoment ausübt und dadurch den Rotor 12 so lange in eine Drehbewegung versetzt, bis die Feldrichtung des Magnetfeldes der Ansteuerspulen 15 parallel zu der Feldrichtung des Rotors 12 ist und der magnetische Nordpol des Rotors 12 vor dem magnetischen Südpol des Magnetfeldes der Ansteuerspulen 15 liegt, vorausgesetzt, daß keine weiteren Kräfte auf den Rotor 12 wirken.

Die Kennbuchstaben "a", "b", "c", "d" dienen dabei als Richtungsindikatoren zur Erleichterung der Erläuterung der Funktionsweise des Schrittmotors 14 und der Verfahren zur Verringerung unkontrollierter Zeigerbewegungen. Folgende Terminologie wird dabei verwendet: Die Feldrichtung des Magnetfeldes der Ansteuerspulen 15 hat dann die Richtung "a", wenn die Amplitudenwerte der Ansteuerspannungen U₁, U₂ an den Ansteuerspulen 15 so eingestellt sind, daß sich der magnetische Südpol des Magnetfeldes der Ansteuerspulen 15 vor dem mit dem Buchstaben "a" gekennzeichneten Spulenkern 13 befindet, d.h. daß sich der magnetische Nordpol des Rotors 12 vor dem Spulenkern 13, der mit dem Buchstaben "a" gekennzeichnet ist, in eine stabile Position bewegen würde, sofern außer der Kraft des Magnetfeldes der Ansteuerspulen 15 keine anderen Kräfte auf den Rotor 12 wirken würden. Der Rotor 12 befindet sich dann in der Position "a", wenn sein Nordpol vor dem Spulenkern 13, der mit dem Buchstaben "a" gekennzeichnet ist, befindet. Eine Position des Rotors 12 wird hierbei dann als "stabile Position" bezeichnet, wenn sie sich bei gleichbleibender Einstellung der Amplitudenwerte der Ansteuerspannungen U₁, U₂ mit der Zeit nicht mehr ändert und wenn sich der Rotor 12 bei einer geringen Auslenkung aus dieser Position selbständig wieder in diese Position zurückbewegt. Im Gegensatz dazu wird als "labile Position" des Rotors 12 bezeichnet, wenn sich zwar bei gleichbleibender Einstellung der Amplitudenwerte der Ansteuerspannungen U₁, U₂ die Position mit der Zeit nicht mehr ändert, aber sich der Rotor 12 bei einer geringen Auslenkung aus dieser Position von der Position weiter weg bewegen würde. Eine "instabile Position" ist eine Position, in der der Rotor 12 aufgrund eines Ungleichgewichts aller auf ihn einwirkenden Drehmomente nicht verharrt, sondern sich mit fortschreitender Zeit in eine andere Position bewegt. Das Drehmoment, welches durch das Magnetfeld der Ansteuerspulen 15 auf den Rotor 12 wirkt wird "Rotormoment M₁₂" genannt.

In der Figur 1 ist nun der Fall dargestellt, wenn auf den Rotor 12 durch das Magnetfeld der Ansteuerspulen 15 ein Drehmoment ausgeübt wird, welches den Rotor 12 im Gegenuhrzeigersinn bewegen möchte. Durch den mechanischen Anschlag 11 wird der Rotor 12 jedoch in seiner Drehbewegung behindert. Der mechanische Anschlag 11 übt seinerseits nun auf den Zeiger 10 ein Drehmoment aus, welches "Zeigermoment M₁₀" genannt wird. Bei einem Anlegen der Ansteuerspannungen U₁, U₂ so daß eine Feldrichtung des Magnetfeldes der Ansteuerspulen 15 in Richtung "b" resultiert, also bei der Feldrichtung "b", dreht sich somit der Rotor 12 mit seinem magnetischen Nordpol nicht ganz vor den Spulenkern 13 mit dem Buchstaben "b", sondern bleibt in einer stabilen Position stehen, die von der Position "b" um einen Differenzwinkel entfernt ist. Der Differenzwinkel ist dabei vor allem abhängig von den Elastizitäten des Zeigers 10, der Welle 20 und des mechanischen Anschlags 11. Die stabile Position des Rotors 12 ist dadurch gekennzeichnet, daß die auf den Zeiger 10 durch den mechanischen Anschlag 11 ausgeübte Zeigerkraft F_{Zeig} gleich groß ist, wie die durch das Drehmoment des Magnetfeldes der Ansteuerspulen 15 auf den Rotor 12 und somit über die Welle 20 auf den Zeiger 10 ausgeübte Rotorkraft F_{Rot}. Bleibt die Ansteuerspannung U₁, U₂ so erhalten, so bleibt der Rotor 12 in dieser Position stehen. Diese Position ist die stabile Position, bei der die beiden im Gleichgewicht befindlichen Drehmomente den maximal möglichen Wert aufweisen, bei dem ein Gleichgewicht möglich ist und wird "stabile Endposition" genannt. Würden nun die Ansteuerspannungen U₁, U₂ mit einem Mal abgeschaltet, so würde sich durch die plötzliche Verringerung der Rotorkraft F_{Rot} die Zeigerkraft F_{Zeig} schlagartig auflösen, wodurch der Zeiger 10 im Uhrzeigersinn vom Anschlag 11 abheben würde.

Üblicherweise ist zwischen den Rotor 12 und den Zeiger 10 ein Getriebe geschaltet, welches eine Übersetzung beinhaltet, bei der sich der Zeiger 10 nur um einen Bruchteil des Winkels bewegt, um den sich der Rotor 12 bewegt. Auch bei einem solchen Getriebe ist meist eine Elastizität vorhanden, die hauptsächlich durch die Elastizität der verwendeten Ritzel und das Getriebespiel entsteht. Solch ein Getriebe erlaubt nun auch, daß sich der Rotor 12 zwischen dem Zeitpunkt des Anschlagens des Zeigers 10 am mechanischen Anschlag 11 und dem Zeitpunkt des Erreichens der stabilen Endposition mehrere Male ganz um sich selbst dreht. Nach dem Erreichen der stabilen Endposition wird üblicherweise die Ansteuerung des Schrittmotors 14 so geändert, daß sich das Magnetfeld der Ansteuerspulen 15 nicht mehr dreht, sondern das Magnetfeld der Ansteuerspulen 15 in einer Winkelposition festgehalten. Der Rotor 12 verharrt nun in einer stabilen Position, die nicht unbedingt gleich der stabilen Endposition sein muß. Danach soll der Schrittmotor 14 ausgeschaltet werden, d.h. die Amplitudenwerte der Ansteuerspannungen U₁, U₂ auf Null herabgesenkt werden. Hier setzt nun die Erfindung ein. Es soll erreicht werden, daß der Schrittmotor 14 so abgeschaltet wird, daß die Stärke einer bei einem schlagartigen Abschalten mit hoher Wahrscheinlichkeit auftretenden unkontrollierten Zeigerbewegung verringert oder gar ganz vermieden wird. Anstelle des schlagartigen Abschaltens der Ansteuerspannungen U₁, U₂ tritt ein Verfahren, mittels dem die Rotorkraft F_{Rot} und somit auch die Zeigerkraft F_{Rot} langsamer abgebaut wird, als beim schlagartigen Abschalten. Der Rotor 12 bewegt sich dabei mit einer begrenzten Geschwindigkeit, so daß ein sichtbares Abheben des Zeigers 10 vom mechanischen Anschlag 11 auf ein Minimum reduziert ist. Das Verfahren läßt sich dabei in drei prinzipielle Verfahrenstypen unterteilen, die nun nacheinander erläutert werden.

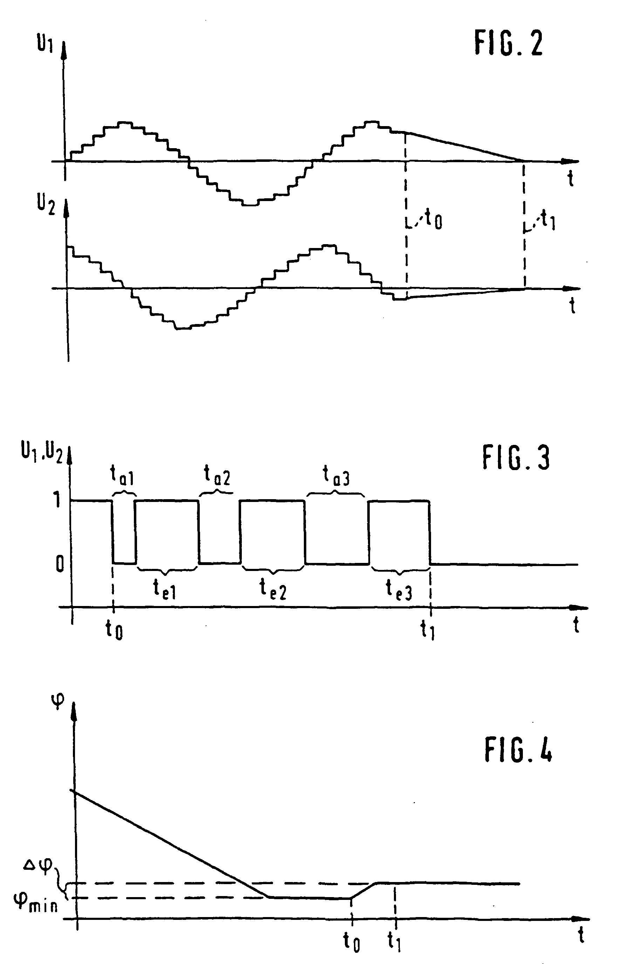

Allen Verfahrenstypen ist gemeinsam, daß sich der Rotor 12 zur langsamen Entspannung der Rotorkraft F_{Rot} im Uhrzeigersinn bewegt. Dabei soll einheitlich als Grundlage der in den weiteren Figuren 2 bis 16 gezeigten Diagramme davon ausgegangen werden, daß im Schrittmotor 14 eine Elastizität, beispielsweise aufgrund eines Zwischengetriebes, vorhanden ist, die groß genug ist, daß sich der Rotor 12 nach dem Zeitpunkt des Anstoßens des Zeigers 10 am mechanischen Anschlag 11 mehrere Male um sich selbst im Gegenuhrzeigersinn dreht, bis die stabile Endposition erreicht ist. Somit sind umgekehrt auch mehrere Umdrehungen des Rotors 12 nötig, um ein vollständiges Abbauen der Zeigerkraft F_{Zeig} zu ermöglichen.

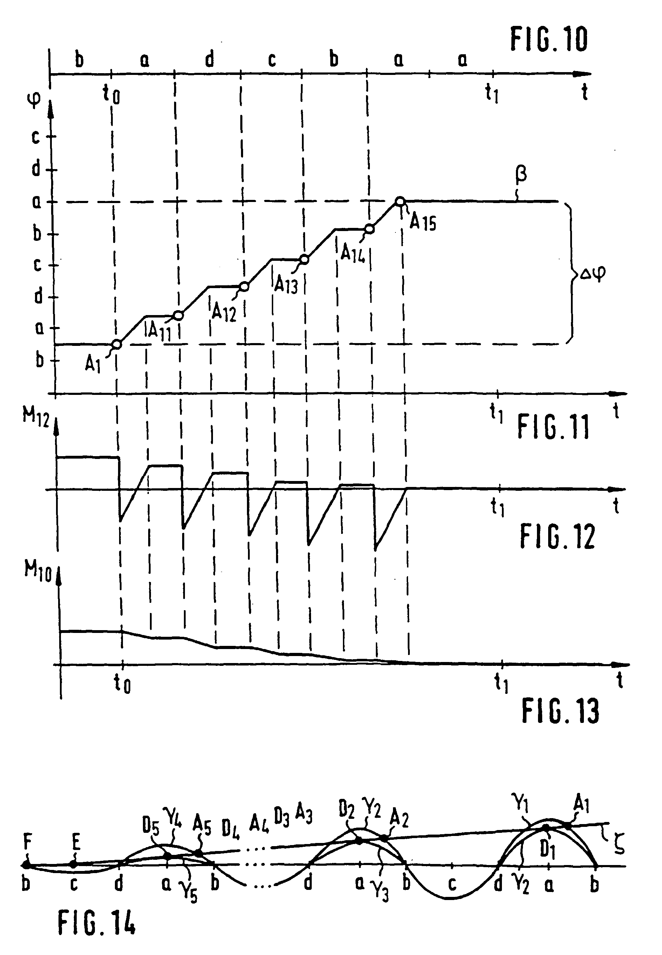

In Figur 2 ist der Verlauf der Ansteuerspannungen U₁, U₂ für den ersten Verfahrenstyp dargestellt. Die Amplituden der beiden Ansteuerspannungen U₁, U₂ verlaufen beide entlang einer Sinuskurve. Die Ansteuerspannung U₁ ist dabei in ihrer Phase gegen die Ansteuerspannung U₂ um 90 Grad verschoben. Dadurch wird ein Drehen des Rotors 12 im Gegenuhrzeigersinn erreicht. Der Rotor 12 wird dabei üblicherweise im Mikroschrittbetrieb betrieben, d.h. die Sinuskurven werden in diskreten Stufen angenähert, wobei eine Stufe einem Mikroschritt entspricht. Schlägt nun der Zeiger 10 zu einem beliebigen Zeitpunkt am mechanischen Anschlag 11 an, so dreht sich der Rotor 12 so lange weiter, bis die stabile Enposition erreicht ist und das vom Magnetfeld der Ansteuerspulen 15 auf den Rotor 12 und auch auf den Zeiger 10 ausgeübte Rotordrehmoment M₁₀ gleich dem durch den mechanischen Anschlag 11 auf den Zeiger 10 ausgeübten Zeigerdrehmoment M₁₂ ist. Der Rotor 12 verharrt in dieser Position, während sich die Feldrichtung des Magnetfelds der Ansteuerspulen 15 weiterhin im Gegenuhrzeigersinn weiterbewegt. Der Rotor 12 folgt dieser Feldbewegung nicht mehr. Da das Rotormoment M₁₂ vom Differenzwinkel zwischen der Feldrichtung des Magnetfelds des Rotors 12 und der Feldrichtung des Magnetfelds der Ansteuerspulen 15 abhängt führt der Rotor 12 kleine, um die stabile Endposition schwankende Pendelbewegungen aus. Soll nun der Schrittmotor 14 in dieser Situation abgeschaltet werden, so wird zunächst die Drehbewegung des Magnetfeldes der Ansteuerspulen 15 gestoppt, indem die Amplitudenwerte der Ansteuerspannungen U₁, U₂ zeitlich konstant gehalten werden. Dadurch ändert sich das Rotormoment M₁₂ nicht mehr und die Pendelbewegungen des Rotors 12 klingen ab. Der Rotor 12 bewegt sich in eine stabile Position, wo Drehmomentgleichgewicht herrscht. Der dann vorliegende Zustand des Schrittmotors 14 wird nun als Ausgangspunkt für die drei verschiedenen Verfahrenstypen verwendet. Kennzeichnend für den ersten Verfahrenstyp ist der folgende Ablauf: Es werden ab einem Startzeitpunkt t₀ die Amplitudenwerte der Ansteuerspannungen U₁, U₂ kontinuierlich abgesenkt. Die Phasenbeziehung der beiden Ansteuerspannungen U₁, U₂ zueinander wird dabei nicht mehr verändert. Durch die Absenkung der Amplituden der Ansteuerspannungen U₁, U₂ wird das Rotormoment M₁₂ vermindert, wodurch sich der Zeiger 10, dem Zeigermoment M₁₀ folgend, im Uhrzeigersinn dreht. Dabei verringert sich dann auch das Zeigermoment M₁₀. Beide Drehmomente werden damit also verringert. Da die Stärke einer unkontrollierten Zeigerbewegung beim schlagartigen Abschalten des Schrittmotors von der zu diesem Zeitpunkt vorliegenden Größe der Zeigerkraft F_{Zeig} und damit vom Zeigermoment M₁₀ abhängt, verringert sich die zu erwartende Stärke der unkontrollierten Zeigerbewegung ebenfalls. Schaltet man den Schrittmotor 14 erst nach dem Absenken der Ansteuerspannungen U₁, U₂ auf einen geringeren Amplitudenwert ab, so verringert sich also das Ausmaß einer unkontrollierten Zeigerbewegung. Vorzugsweise werden die Amplituden der Ansteuerspannungen U₁, U₂ ganz abgesenkt. Zu einem Endzeitpunkt t₁ sind dann die Amplituden der Ansteuerspannungen U₁, U₂ beide auf den Wert Null abgesunken. Insbesondere ist durch das kontinuierliches Absenken der Ansteuerspannungen U₁, U₂ bis zum Wert Null erreichbar, daß überhaupt keine unkontrollierte Zeigerbewegung mehr auftritt. Näheres zu diesem ersten Verfahrenstyp wird anhand der Figuren 14 bis 16 erläutert werden.

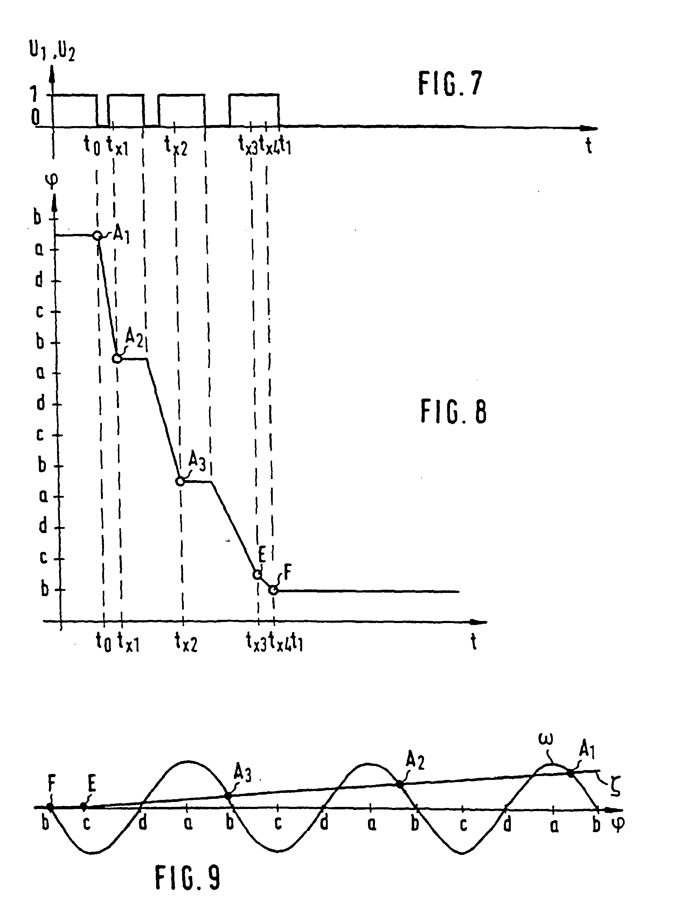

Als zweiter Verfahrenstyp zur Entspannung der Zeigerkraft F_{Zeig} ist, wie in Figur 3 dargestellt, es vorgesehen, ab dem Startzeitpunkt t₀ beide Ansteuerspannungen U₁, U₂ für eine erste Abschaltzeitspanne tₐ₁ abzuschalten und danach für eine erste Einschaltzeitspanne tₑ₁ wieder einzuschalten. Es folgen mehrere solcher Vorgänge mit einer zweiten Abschaltzeitspanne tₐ₂, einer zweiten Einschaltzeitspanne tₑ₂, einer dritten Abschaltzeitspanne tₐ₃ und einer dritten Einschaltzeitspanne tₑ₃. Nach der dritten Einschaltzeitspanne tₑ₃ ist der Endzeitpunkt t₁ erreicht und der Schrittmotor 14 wird nicht mehr eingeschaltet. Während der Abschaltzeitspannen tₐ₁, tₐ₂, tₐ₃ bewegt sich der Rotor 12 aus seiner stabilen Position in Richtung der Zeigerkraft F_{Zeig} und wird während der Einschaltzeitspannen tₑ₁, tₑ₂, tₑ₃ wieder vom Magnetfeld der Ansteuerspulen 15 des wieder eingeschalteten Schrittmotors 14 in einer stabilen Position mit geringerem Rotormoment M₁₂ aufgefangen und in dieser Position stabilisiert. Auf diese Weise verringert sich mit jeder Rotorumdrehung das Rotormoment M₁₀ um einen bestimmten Betrag und damit auch die Zeigerkraft F_{Zeig}. Die Rotorumdrehungen werden durch das Verfahren zeitlich gesteuert und laufen dadurch kontrolliert ab. Auch hier wird also durch schrittweises Verringern des Zeigermoments M₁₀ die Stärke einer zu erwartenden unkontrollierten Zeigerbewegung verringert. Näheres zu diesem verfahren wird anhand der Figuren 7 bis 9 erläutert werden.

Den Drehwinkelverlauf für den dritten Verfahrenstyp zeigt die Figur 4. Der Drehwinkel ϕ des Rotors 12 vermindert sich mit der Bewegung des Rotors 12 im Gegenuhrzeigersinn. Sobald der Rotor 12 durch das anwachsende Zeigermoment M₁₀ zum Stillstand abgebremst wird und in die stabile Endposition gezwungen wird, ist ein minimaler Drehwinkel ϕₘᵢₙ erreicht. Der dritte Verfahrenstyp sieht nun vor, daß, bevor der Schrittmotor 14 abgeschaltet wird, der Rotor 12 ab dem Startzeitpunkt t₀ durch Ansteuerung der Ansteuerspulen 15 mit einer Richtungsumkehr um einen Ausgleichsdrehwinkel Δϕ im Uhrzeigersinn bewegt wird, wodurch gleichfalls die Zeigerkraft F_{Zeig} verringert wird. Auch diese Drehbewegung des Rotors 12 geschieht im Gegensatz zur Drehbewegung beim abrupten Abschalten kontrolliert und gesteuert. Nach Erreichen des Ausgleichsdrehwinkels Δϕ wird der Schrittmotor 14 zum Endzeitpunkt t₁ ausgeschaltet. Da der Rotor 12 vor dem Abschalten um den Ausgleichsdrehwinkel Δϕ bewegt wurde, wirkt zum Endzeitpunkt t₁ nur eine verringerte Zeigerkraft F_{Zeig} auf den Rotor 12, wodurch die Stärke eines unkontrollierten Abhebens des Zeigers 10 vom mechanischen Anschlag 11 verringert wird. Im optimalen Fall wird der Ausgleichsdrehwinkel Δϕ gerade so groß gewählt, daß das Zeigermoment M₁₀ auf den Wert Null abgesunken ist. Näheres zu diesem Verfahren wird anhand der Figuren 10 bis 13 erläutert werden.

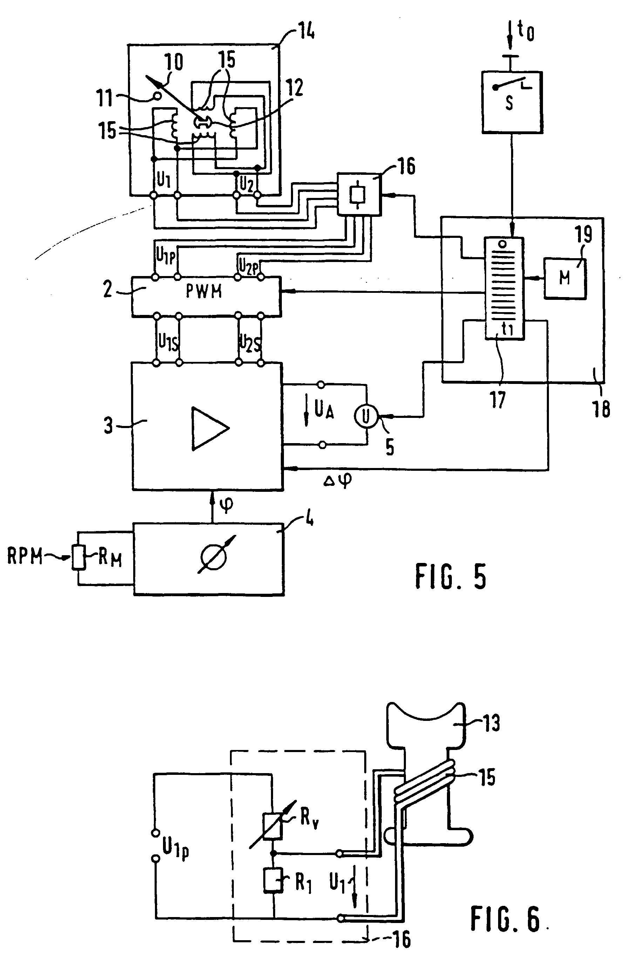

In Figur 5 ist eine Anordnung dargestellt, wie sie zur Ansteuerung des Schrittmotors 14 verwendet wird, um das Verfahren auszuführen. Ein Meßgerät 4, welches einen Meßwiderstand R_{M} aufweist, ist einem Schrittmotortreiber 3 vorgeschaltet. Der Schrittmotortreiber 3 liefert an seinen zwei Ausgängen die Treiberspannungen U₁ₛ, U₂ₛ welche einem Pulsweitenmodulator 2 zugeleitet werden. Zwischen den Ausgängen des Pulsweitenmodulators 2, an denen pulsweitenmodulierte Spannungen U₁ₚ, U₂ₚ anliegen, und den Eingängen des Schrittmotors 14 ist eine Impedanzschaltung 16 angeordnet, an deren Ausgänge die Ansteuerspannungen U₁, U₂ anliegen. Der Schrittmotortreiber 3 weist außerdem zwei Eingangsanschlüsse auf, an denen eine Versorgungsspannung U_{A} anliegt, die mittels einer versorgungsspannungsquelle 5 generiert wird. Weiter ist eine Abschalteinrichtung 18 vorgesehen, die ein Speichermedium 19 und eine Ablaufsteuerung 17 aufweist. Ein Schalter S ist mit der Ablaufsteuerung 17 verbunden, welche vier Ausgänge aufweist, von denen einer mit der Impedanzschaltung 16, einer mit dem Pulsweitenmodulator 2, der dritte mit der versorgungsspannungsquelle 5 und der vierte mit dem Schrittmotortreiber 3 verbunden ist. Das Speichermedium 19 ist mit der Ablaufsteuerung 17 verbunden.

Das Meßgerät 4 dient über den Meßwiderstand R_{M} beispielsweise zur Messung einer Temperatur oder Drehzahl RPM und zur Umsetzung des ermittelten Meßwertes in einen am Schrittmotor 14 einzustellenden Drehwinkel ϕ. Der Wert des einzustellenden Drehwinkels ϕ wird vom Meßgerät 4 dem Schrittmotortreiber 3 mitgeteilt, welcher wiederum eine Umsetzung des Wertes des einzustellenden Drehwinkels ϕ in zwei entsprechende Werte der Treiberspannungen U₁ₛ, U₂ₛ bewirkt. Der Pulsweitenmodulator 2 wandelt die ihm zugeführten Werte der Treiberspannungen U₁ₛ, U₂ₛ in entsprechende pulsweitenmodulierte Ansteuerspannungen U₁ₚ, U₂ₚ um. Die pulsweitenmodulierten Ansteuerspannungen U₁ₚ, U₂ₚ gelangen dann über die Impedanzschaltung 16, deren Aufbau im Zusammenhang mit Figur 6 näher beschieben werden wird, zum Schrittmotor 14, wo die ankommenden Spannungswerte für die Ansteuerspannungen U₁, U₂ an die Ansteuerspulen 15 gelangen und ein Verdrehen des gemeinsam mit dem Rotor 12 auf der Welle 20 montierten Zeigers 10 bewirken. Es ist nun vorgesehen, daß nach Betätigung des Schalters S die Ablaufsteuerung 17 gestartet wird, woraufhin eines oder mehrere der drei vorgenannten Verfahrentypen vor dem Abschalten des Schrittmotors 14 durchgeführt werden. Für die Verringerung der Feldstärke des Schrittmotors 14 gemäß dem ersten Verfahrenstyp sind über die Verbindung zwischen der Abschalteinrichtung 18 und der Impedanzschaltung 16 Impedanzwerte von in der Impedanzschaltung 16 vorhandenen Impedanzen veränderbar, so daß die Amplituden der Ansteuerspannungen U₁, U₂ verringert werden. Ebenso ist es vorgesehen, daß die Ablaufsteuerung 17 eine Verringerung der Pulsweite der pulsweitenmodulierten Ansteuerspannungen U₁ₚ, U₂ₚ im Pulsweitenmodulator 2 bewirkt. Weiter ist es vorgesehen, die Feldstärke des Magnetfeldes der Ansteuerspulen 15 im Schrittmotor 14 dadurch zu verringern, daß die Versorgungsspannung U_{A} des Schrittmotortreibers 3 verringert wird. Alle drei Einwirkungsmöglichkeiten, also auf die Impedanzschaltung 16, den Pulsweitenmodulator 2 und den Schrittmotortreiber 3 können so angesteuert werden, daß die Feldstärke des Magnetfeldes der Ansteuerspulen 15 kontinuierlich oder in diskreten Stufen auf einen niedrigeren Wert abgesenkt wird. Ebenso können alle drei Einwirkungsmöglichkeiten so angesteuert werden, daß gemäß dem zweiten Verfahrenstyp mehrere Aus- und Einschaltvorgänge realisiert werden. Die vierte Ausgangsleitung der Ablaufsteuerung 17 ist direkt zum Schrittmotortreiber 3 geführt, wo eine Einflußnahme der Ablaufsteuerung 17 auf den Drehwinkel ϕ gemäß dem dritten Verfahrenstyp vornehmbar ist. Die Ablaufsteuerung 17 entnimmt zunächst dem Speichermedium 19 den Wert für den Ausgleichsdrehwinkel Δϕ um ihn dann dem Schrittmotortreiber 3 mitzuteilen, woraufhin dieser eine Bewegung des Rotors 12 des Schrittmotors 14 um den Ausgleichsdrehwinkel Δϕ weg vom mechanischen Anschlag 11 ansteuert. Die Betätigung des Schalters S erfolgt dabei zum Startzeitpunkt t₀ und die Beendigung des Abschaltvorganges durch die Ablaufsteuerung 17 erfolgt zum Endzeitpunkt t₁. Die Ablaufsteuerung 17 ist vorzugsweise so ausgebildet, daß eine Anpassung des Abschaltverfahrens an veränderliche, die Elastizitäten der verspannten Elemente beeinflussende Umweltgrößen, wie Temperatur, Feuchtigkeit erfolgt. Dazu ist dann natürlich dafür zu sorgen, daß die entsprechenden Parameterwerte der Umweltgrößen von Meßeinrichtungen zur Ablaufsteuerung 17 gelangen.

In der Figur 6 ist eine Ausführungsform für die Impedanzschaltung 16 dargestellt. Dabei ist ein Spannungsteiler aus einem Teilerwiderstand R₁ und einem variablen Widerstand Rᵥ parallel zum Eingang der Impedanzschaltung 16, an dem die pulsweitenmodulierte Ansteuerspannung U₁ₚ anliegt, geschaltet. Parallel zum Teilerwiderstand R₁ ist die Ansteuerspule 15, welche auf den Spulenkern 13 gewickelt ist, geschaltet. Die beiden Widerstände R₁, Rᵥ bilden die Impedanzschaltung 16.

Durch Variation des Widerstandswertes des variablen Widerstandes Rᵥ ist so die am Teilerwiderstand R₁ abfallende Spannung, welche die Ansteuerspannung U₁ für die Ansteuerspule 15 bildet, varierbar. Somit kann der Abschaltvorgang durch die Ablaufsteuerung 17 mittels Wertänderung des Widerstandswertes des variablen Widerstandes Rᵥ eine Wertänderung der Amplitude der Ansteuerspannung U₁ bewirken.

In Figur 7 ist der Spannungsverlauf der Ansteuerspannungen U₁, U₂ für den dritten Verfahrenstyp dargestellt. Der daraus resultierende Verlauf des Drehwinkels ϕ des Rotors 12 ist in Figur 8 dargestellt und ein die stabilen Positionen anhand der Momente M₁₀, M₁₂ des Zeigers 10 und des Rotors 12 darstellendes Diagramm zeigt Figur 9. Die Funktionsweise des dritten Verfahrenstyps soll nun anhand der Figuren 7, 8 und 9 im Zusammenhang erläutert werden. Es wird davon ausgegangen, daß der Rotor 12 sich vor dem Startzeitpunkt t₀ in einer stabilen Position befindet, welche den magnetischen Nordpol des Rotors 12 zwischen den Positionen "a" und "b" festlegt. Dabei wird weiterhin angenommen, daß die Ansteuerspulen 15 so bestromt sind, daß ihr Magnetfeld den magnetischen Nordpol des Rotors 12 in die Position "b" drehen möchte. Diese Feldrichtung "b" bleibt bei diesem dritten Verfahrenstyp konstant. In Figur 9 ist eine Linie ζ eingezeichnet, welche den idealisierten Verlauf des Zeigermoments M₁₀ in Abhängigkeit vom Drehwinkel ϕ darstellt. Der Verlauf des Rotormoments M₁₂ ist durch die Linie ω repräsentiert. Die stabile Position, in der sich der Rotor 12 vor dem Startzeitpunkt t₀ befindet, ist mit dem Kennbuchstaben "A₁" gekennzeichnet. Im stabilen Ruhezustand zwischen den Positionen "a" und "b" ist das Zeigermoment M₁₀ des Zeigers 10 genauso groß wie das Rotormoment M₁₂ des Rotors 12. Zum Startzeitpunkt t₀ werden die Ansteuerspannungen U₁, U₂ abgeschaltet. Das Zeigermoment M₁₀ beginnt daraufhin aufgrund des abgeschalteten Magnetfeldes der Ansteuerspulen 15 des Schrittmotors 14 den Zeiger 10 im Uhrzeigersinn in Richtung der Position "a" zu drehen. Der Zeiger 10 bewegt sich dabei nacheinander über die Positionen "a", "d", "c" und "b" hinweg. Zwischen dem Zeitpunkt, zu dem der Zeiger 10 die Position "a" überstreicht und dem Zeitpunkt, zu dem der Zeiger 10 die Position "b" überstreicht werden die Ansteuerspannungen U₁, U₂ wieder eingeschaltet. Das im Schrittmotor 14 erneut entstehende Magnetfeld der Ansteuerspulen 15 im Schrittmotor 14 fängt daraufhin die Drehbewegung des Rotors 12 und damit auch des Zeigers 10 ab und zwingt den Rotor 12 zu einem ersten Einfangzeitpunkt tₓ₁ in eine neue stabile Position, welche wiederum zwischen den Positionen "a" und "b" liegt. Da das Zeigermoment M₁₀ während dieser Umdrehung des Rotors 12 verringert wurde, liegt die neue stabile Position "A₂" näher bei Position "b". Nachdem der Rotor 12 in der neuen stabilen Position "A₂" vom Magnetfeld der Ansteuerspulen 15 eingefangen wurde, werden die Ansteuerspannungen U₁, U₂ erneut ausgeschaltet. Daraufhin beginnt ein erneuter Drehvorgang des Rotors 12 über die Positionen "a", "d", "c" und "b" hinweg zu einer dritten stabilen Position "A₃". Der Rotor 12 wird zu einem zweiten Einfangzeitpunkt tₓ₂ in der dritten stabilen Position "A₃" eingefangen, da das Magnetfeld der Ansteuerspulen 15 durch erneutes Einschalten der Ansteuerspannungen U₁, U₂ rechtzeitig vor dem Zeitpunkt eingeschaltet wurde, zu dem der Rotor 12 die Position "b" überstreicht. Erneut wurde das Zeigermoment M₁₀ durch diese Rotation des Rotors 12 verringert, wodurch die dritte stabile Position "A₃" wiederum näher bei der Position "b" liegt. Die Rotationsgeschwindigkeit des Rotors 12 nimmt aufgrund des abnehmenden Zeigermomentes M₁₀ bei jeder Drehbewegung im Uhrzeigersinn ab. Dies ist in der Figur 8 daran zu erkennen, daß die Steilheit der steilen Flanken zwischen den stabilen Positionen "A₁", "A₂", und "A₃" mit steigender Zeit t und sinkendem Drehwinkel ϕ abnimmt. Ein erneutes Abschalten der Ansteuerspannungen U₁, U₂ bewirkt eine erneute Drehbewegung des Rotors 12, der ausgehend von der stabilen Position "A₃" nacheinander die Positionen "a", "d" und "c" überstreicht. Nach dem Passieren der Position "c" ist das Zeigermoment M₁₀ auf den Wert Null abgesunken, d.h. der Zeiger 10 liegt nun ohne Zeigerkraft F_{Zeig} am mechanischen Anschlag 11 an. Die instabile Position in der sich der Rotor 12 zu diesem ersten Nullmomentzeitpunkt tₓ₃ befindet trägt den Kennbuchstaben "E". Da der Schrittmotor 14 aber noch eingeschaltet ist wirkt noch das Rotormoment M₁₂ aufgrund des Differenzwinkels zwischen den Positionen "E" und "b" auf den Rotor 12. Somit wirkt auf den Rotor 12 ab dem Zeitpunkt des Erreichens der instabilen Position "E" nur noch das Rotormoment M₁₂. Dieses Rotormoment M₁₂ bewirkt eine Drehung des Rotors 12 von der instabilen Position "E" zu einer stabilen Position "F", die mit der stabilen Position "b" identisch ist. Da in der stabilen Position "F" kein Drehmoment mehr auf den Rotor 12 wirkt, verharrt der Rotor 12 in der stabilen Position "b". Nachdem der Rotor 12 die Position "b" zum zweiten Nullmomentzeitpunkt tₓ₄ erreicht hat, werden die Ansteuerspannungen U₁, U₂ zum Endzeitpunkt t₁ endgültig abgeschaltet. Ein weiteres Ein- oder Abschalten der Ansteuerspannungen U₁, U₂ bliebe nun wirkungslos und der Zeiger 10 bliebe in seiner Position stehen. Somit wurde erreicht, daß das Zeigermoment M₁₀ schrittweise abgebaut wurde, wobei sich der Rotor 12 maximal um eine Umdrehung am Stück drehen konnte. Wenn der Zeiger 10 mit dem Rotor 12 über die ein Untersetzungsgetriebe verbunden ist, bewirkt die maximale Drehung des Rotors 12 um eine Umdrehung eine entsprechend geringe Drehbewegung des Zeigers 10. Es kommt dabei zu keinem störenden Abheben des Zeigers 10 vom mechanischen Anschlag 11.

Bezüglich der Wahl der Längen der Einschaltzeitspannen tₑ₁, tₑ₂, tₑ₃ und der Abschaltzeitspannen tₐ₁, tₐ₂, tₐ₃ können folgende Dimensionierungshinweise gegeben werden: Da die Drehgeschwindigkeit des Rotors 12 mit abnehmendem Zeigermoment M₁₀ ebenfalls abnimmt, sollten die nacheinander folgenden Abschaltzeitspannen tₐ₁, tₐ₂, tₐ₃ ansteigend gewählt werden. Der Rotor 12 muß, um während einer Abschaltzeitspanne tₐ₁, tₐ₂, tₐ₃ nahezu eine ganze Umdrehung auszuführen, während der Abschaltzeitspanne tₐ₁, tₐ₂, tₐ₃ zumindest über die Position "a" hinaus drehen, damit er nicht beim erneuten Einschalten erneut in seine vorherige stabile Position zurückgezogen wird. Andererseits sollte die Abschaltzeitspanne tₐ₁, tₐ₂, tₐ₃ so kurz gewählt werden, daß das Magnetfeld der Ansteuerspulen 15 während der nachfolgenden Einschaltzeitspanne tₑ₁, tₑ₂, tₑ₃ so rechtzeitig wieder aufgebaut ist, daß der sich drehende Rotor 12 in der nächsten stabilen Position, d.h. nach etwas weniger als einer ganzen Rotorumdrehung, vom Magnetfeld der Ansteuerspulen 15 aufgefangen und in diese stabile Position gezwungen wird. Die Einschaltzeitspanne tₑ₁, tₑ₂, tₑ₃ sollte wiederum so groß gewählt werden, daß ein ausreichendes Abbremsen des sich drehenden Rotors 12 in der stabilen Position erfolgt. So wird erreicht, daß der Rotor 12 nicht noch aus der gerade ausgeführten Umdrehung Energie mit für die folgende Umdrehung mitnimmt, was zu einer Erhöhung der während der Umdrehung erreichten Geschwindigkeit des Rotors 12 führen würde. Es ist im Sinne der Erfindung, wenn die maximale Rotorgeschwindigkeit beim Abschalten des Schrittmotors 14 auf einen so geringen Wert begrenzt wird, daß im Idealfall kein Abheben des Zeigers 10 hervorgerufen wird. Bezüglich des in den Figuren 7 bis 9 dargestellten Beispiels sollte die Einschaltzeitspanne tₑ₁, tₑ₂, tₑ₃ also nach dem Zeitpunkt, zu dem der Rotor 10 die Position "a" erreicht beginnen und nach dem Zeitpunkt, zu dem der Rotor 10 die Position "A₃" erreicht enden.

In der Figur 10 ist der zeitliche Verlauf der Richtung des Magnetfeldes der Ansteuerspulen 15 im Schrittmotor 14 für den zweiten Verfahrenstyp dargestellt. Figur 11 zeigt den dazugehörigen Verlauf des Drehwinkels ϕ des Rotors 12 anhand der dort eingezeichneten Kurve β. Weiter zeigen die Figur 12 den ungefähren Verlauf des Rotormoments M₁₂ und Figur 13 den ungefähren Verlauf des Zeigermoments M₁₀. Anhand der Figuren 10 bis 13 soll der zweite Verfahrenstyp nun erläutert werden.

Als Ausgangspunkt dient hier ebenfalls wieder die Annahme, daß der Rotor 12 vor dem Startzeitpunkt t₀ mit seinem magnetischen Nordpol zwischen den Positionen "a" und "b" in einer stabilen Position "A₁" liegt. Das Magnetfeld der Ansteuerspulen 15 hat zunächst die Feldrichtung "b". Ab dem Startzeitpunkt t₀ wird nun die Feldrichtung des Magnetfeldes der Ansteuerspulen 15 umgeschaltet, so daß die neue Feldrichtung des Magnetfeldes der Ansteuerspulen 15 in Richtung der Position "a" zeigt. Dies entspricht einem Vollschrittbetrieb, der hier zur Vereinfachung der Erläuterung des Verfahrensablaufs angenommen wird. Der Verfahrenstyp ist aber ebenso für einen Mikroschrittbetrieb geeignet. Durch die Umschaltung der Feldrichtung des Magnetfeldes der Ansteuerspulen 15 dreht sich das Vorzeichen des Rotormoments M₁₂ um und bewirkt eine Drehbewegung des Rotors 12 im Uhrzeigersinn. Der Rotor 12 bewegt sich dabei über die Position "a" hinweg in eine zweite stabile Position "A₁₁". Das Rotormoment M₁₂ befindet sich dabei wieder auf einem gleichbleibenden Wert, der gleich dem Zeigermoment M₁₀ ist. Die Drehgeschwindigkeit des Rotors 12 wächst dabei nicht so stark an, wie beim ersten und dritten Verfahrenstyp, da der Rotor hier weniger als eine Vierteldrehung vollführt, bis er wieder abgebremst wird. Dazu wird vorzugsweise die Drehfrequenz der Feldrichtung des Magnetfeldes der Ansteuerspulen 15 niedriger gewählt, als beim herkömmlichen Drehbetrieb des Rotors 12 zur Anzeige von Meßwerten auf der Skalenscheibe. Es erfolgt daraufhin ein weiteres Umschalten der Feldrichtung des Magnetfeldes der Ansteuerspulen 15 in Richtung der Position "d", so daß ein erneuter Drehvorgang des Rotors 12 in Uhrzeigersinn erfolgt. Das Zeigermoment M₁₀ nimmt dabei wiederum auf einen geringeren Wert ab, woraus sich eine erneute dritte stabile Position "A₁₂" bei Gleichheit des Zeigermoments M₁₀ und des Rotormoments M₁₂ ergibt. Es folgen weitere Magnetfeldrichtungswechsel, über die Positionen "c" und "b". Der Rotor 12 bewegt sich dabei über die weiteren stabilen Positionen "A₁₃" und "A₁₄". Sobald das Zeigermoment M₁₀ den Nullpunkt erreicht hat, wirkt nur noch das Rotormoment M₁₂, welches durch das Magnetfeld der Ansteuerspulen 15 auf den Rotor 12 ausgeübt wird und bewegt den Rotor 12 in die gerade durch die Ansteuerspulen 15 vorgegebene Magnetfeldrichtung. In dem Moment, in dem der Rotor 12 sich in Richtung der zuletzt gültigen Magnetfeldrichtung gedreht hat, ist auch das Rotormoment M₁₂ auf den Wert Null abgesunken, so daß keinerlei Momente mehr auf den Rotor 12 wirken. Der Rotor 12 verharrt daher in der letzten stabilen Position "A₁₅". Somit wurde auch hier das Zeigermoment M₁₀ vom Maximalwert schrittweise abgebaut, indem der Rotor 12 um den Ausgleichsdrehwinkel Δϕ im Uhrzeigersinn weg vom mechanischen Anschlag 11 bewegt wurde. Auch hierbei kann somit ein Abheben des Zeigers 10 vom mechanischen Anschlag 11 durch kontrollierten Abbau des Zeigermoments M₁₀ vermieden werden. Die Stärke einer beim Abschalten des Schrittmotors 14 zu erwartenden unkontrollierten Zeigerbewegung wird somit verringert. Im Idealfall wird der Rotor 12 gerade so weit im Uhrzeigersinn gedreht, daß das Zeigermoment M₁₀ Null ist. Dann kann der Schrittmotor 14 abgeschaltet werden, ohne eine unkontrollierte Zeigerbewegung zu verursachen.

Es ist auch vorgesehen, den zweiten Verfahrenstyp kombiniert mit dem ersten oder dritten Verfahrenstyp einzusetzen, indem zusätzlich zur Bewegung um den Ausgleichsdrehwinkel Δϕ die Amplitude der Ansteuerspannungen U₁, U₂ reduziert wird oder abwechselnd Ab- und Einschaltvorgänge erfolgen. Dadurch kann der Abschaltvorgang zusätzlich verkürzt werden.

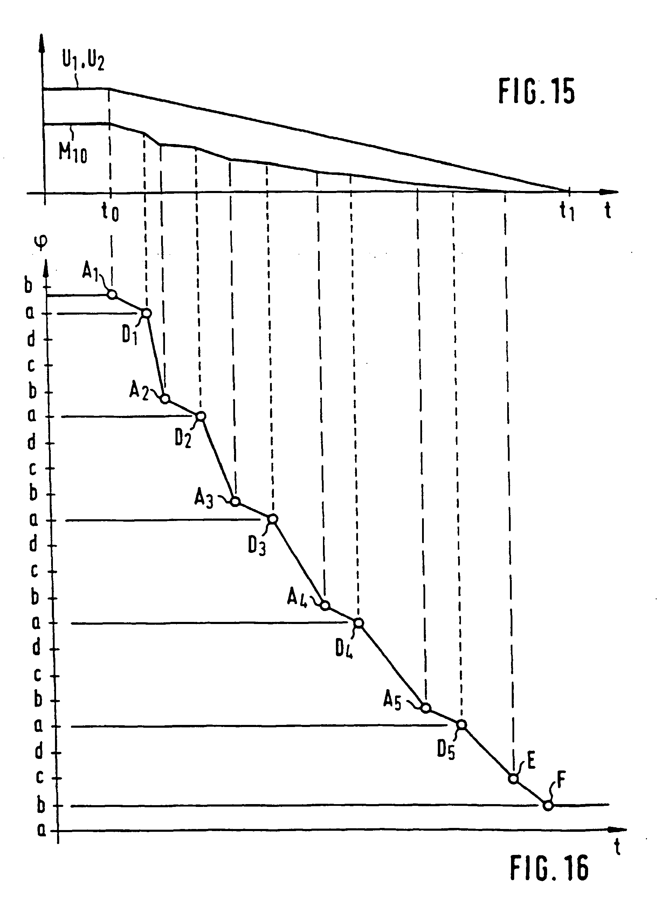

In der Figur 14 ist zum ersten Verfahrenstyp der Verlauf des Zeigermoments M₁₀ anhand der Linie ζ und der Verlauf des Rotormoments M₁₂ anhand der Linien γ₁, γ₂, γ₃ und γ₄ eingezeichnet. In Figur 15 ist der zugehörige Verlauf der Amplituden der Ansteuerspannungen U₁, U₂ sowie der ungefähre Verlauf des Zeigermoments M₁₀ eingetragen. Figur 16 zeigt den zugehörigen Verlauf des Drehwinkels ϕ des Rotors 12. Anhand der Figuren 14, 15 und 16 soll der Ablauf des ersten Verfahrenstyps erläutert werden.

Erneut gilt als Ausgangsposition ein Verharren des Rotors 12 in der stabilen Position "A₁" zwischen den Positionen "a" und "b". Die Feldrichtung des Magnetfeldes der Ansteuerspulen 15 bleibt während des gesamten Verfahrens in Richtung der Position "b". Zum Startzeitpunkt t₀ beginnt die Amplitude der Ansteuerspannungen U₁, U₂ rampenförmig kontinuierlich abzufallen. Daraus resultiert eine kontinuierliche Abschwächung des Magnetfeldes der Ansteuerspulen 15, wodurch sich der Rotor 12 dem Zeigermoment M₁₀ folgend im Uhrzeigersinn bewegt. Dabei reduziert sich außerdem das Zeigermoment M₁₀. Die Bewegung von der stabilen Position "A₁" bis zur Position "a" ist in der Figur 14 gezeigt. Die Amplitude der Ansteuerspannungen U₁, U₂ wird so abgesenkt, so daß sich das Rotormoment M₁₂ vom Verlauf der anfänglichen Kurve γ₁ zum Verlauf der Kurve χ₂ hin verändert. Das Zeigermoment M₁₂ wandert dabei entlang der Linie ζ von der stabilen Position "A₁" zur labilen Position "D₁". Sobald die labile Position "D₁" erreicht ist, würde jede weitere Absenkung der Feldstärke des Magnetfeldes der Ansteuerspulen 15 eine Verringerung des auf den Rotor 12 wirksamen Rotormoments M₁₂ bewirken. Entsprechend kippt der Rotor 12 aus dieser labilen Position "D₁" und dreht sich über die Positionen "d", "c" und "b" hinweg in eine zweite stabile Position "A₂". Diese Position ergibt sich wiederum aus dem Schnittpunkt der Linie ζ mit dem durch die Linie γ₂ repräsentierten Rotormoment M₁₂. Bei einer geringen Absenkgeschwindigkeit ist die Rotorgeschwindigkeit zwischen den Positionen "A₁" und "D₁" dabei vergleichsweise niedriger als die Rotorgeschwindigkeit zwischen den Positionen "D₁" und "A₂", da sie im ersten Fall durch die Geschwindigkeit des Absenkens der Amplituden der Ansteuerspannungen U₁, U₂ und im zweiten Fall durch die mechanische Zeitkonstante des Rotors 12 bestimmt wird. Die mechanische Zeitkonstante ist dabei gleich dem Kehrwert der Eigenfrequenz des Rotors 12 unter Betriebsbedingungen. Diese Eigenfrequenz hängt natürlich auch von den an den Rotor 12 gekoppelten mechanischen Elementen, wie der Welle 20, einem eventuellen Getriebe und auch dem Zeiger 10 ab und bestimmt das Anschwingverhalten des Rotors 12. Durch die Wahl einer geringen Absenkgeschwindigkeit wird der Rotor 12, ähnlich wie es beim dritten Verfahrenstyp mittels der Einschaltphase erreicht wird, nach fast einer Umdrehung wieder abgebremst. Erneut bewirkt das Absenken der Amplituden der Ansteuerspannungen U₁, U₂ eine langsamere Rotordrehung von der stabilen Position "A₂" zu einer zweiten labilen Position "D₂", welche auftritt, wenn das Rotormoment M₁₂ in der Position "a" gerade gleich groß ist wie das Zeigermoment M₁₀. Das Rotormoment M₁₂ ist in diesem Falle durch die Linie γ₃ in der Figur 14 repräsentiert. Auch hier kippt der Rotor 12 erneut aus der labilen Position "D₂" und überstreicht die Positionen "d", "c" und "b" bis zur dritten stabilen Position "A₃". Es folgen so viele weitere solcher Vorgänge, über die Positionen "D₃", "A₄", "D₄", "A₅", "D₅" bis das Zeigermoment M₁₀ auf den Wert Null abgesunken ist. Dann befindet sich der Rotor 12 in der instabilen Position "E". In dieser instabilen Position "E" wirkt auf den Rotor 12 kein Zeigermoment M₁₀ mehr, sondern lediglich der zu diesem Zeitpunkt noch bestehende Anteil des Rotormoments M₁₂. Durch das verbleibende Rotormoment M₁₂ wird der Rotor 12 aus der instabilen Position "E" in die endgültige stabile Position "F" gedreht, welche dadurch gekennzeichnet ist, daß sich der magnetische Nordpol des Rotors 12 vor der Position "b" befindet. Dort verharrt der Rotor 12, bis die Amplituden der Ansteuerspannungen U₁, U₂ auf Null abgesunken sind und der Endzeitpunkt t₁ erreicht ist. Da die Amplituden der Ansteuerspannungen U₁, U₂ bereits den Wert Null haben, ist der Schrittmotor 14 bereits abgeschaltet. Bei diesem ersten Verfahrenstyp wurde es erreicht, daß der Rotor 12 abwechselnd langsame und schnelle Bewegungen durchführt, wobei die schnellen Drehbewegungen auf maximal eine Rotorumdrehung begrenzt sind, wodurch die Geschwindigkeit des Rotors 12 nicht unkontrolliert anwachsen und zu einem Abheben des Zeigers 10 vom mechanischen Anschlag 11 führen kann. Es ist nicht unbedingt notwendig, die Absenkung der Feldstärke des Magnetfeldes der Ansteuerspulen 15 ganz auf den Wert Null herabzusenken. Eine Verringerung der Stärke einer unkontrollierten Zeigerbewegung wird bereits durch das Absinken des Rotormoments M₁₀ während der Bewegung des Rotors 12 von einer labilen Position in eine stabile Position erzielt. Je mehr solcher Vorgänge jedoch vor einem abrupten Abschaltvorgang erfolgen, desto geringer wird diese Stärke.

Allen drei Verfahrenstypen ist somit gemeinsam, daß das Zeigermoment M₁₀ kontrolliert abgebaut wird, so daß es zu einem nicht oder nur kaum sichtbaren Abheben des Zeigers 10 vom mechanischen Anschlag 11 kommt. Es ist ebenso vorgesehen, die drei Verfahrenstypen miteinander zu kombinieren und so eine jeweils dem Anwendungsfall angepaßte Lösung zu erhalten. Dabei ist es z.B. insbesondere möglich, den Rotor 12 zunächst um einen Ausgleichsdrehwinkel Δϕ vom mechanischen Anschlag 11 weg zu bewegen und dann die Amplituden der Ansteuerspannungen U₁, U₂ entweder rampenförmig zu verringern, oder durch mehrere Ein- und Abschaltvorgänge das Zeigermoment M₁₀ abzubauen.

Die in den Figuren 1 bis 16 dargestellte und behandelte Schrittmotor 14 weist vier Ansteuerspulen 15 und vier Spulenkerne 13 auf. Das Verfahren ist jedoch für jeden anderen Typus eines Schrittmotors 14 ebenso geeignet. So ist beispielsweise ein Schrittmotor 14 bekannt, der nur zwei Ansteuerspulen 15 aufweist, deren Spulenkerne 13 C-förmig ausgebildet sind und die an einem Schenkel des Spulenkerns 13 so miteinander verbunden sind, so daß nur drei Stirnseiten eines Spulenkerns 13 in Winkeln von 120° zueinander versetzt auf der Kreislinie angeordnet sind, für den das Verfahren gleichfalls einsetzbar ist.

Als Zeiger 10 im Sinne der Erfindung soll generell ein in etwa senkrecht zur Welle 20 montierter Hebel verstanden werden. Dieser Hebel muß dabei nicht unbedingt zur Anzeige des Drehwinkels ϕ genutzt werden. Es ist beispielsweise vorgesehen, einen ersten Zeiger 10 aus einem steifen Material, z.B. Stahl oder ein anderes Metall, auf der Welle 20 zu montieren, welcher an den mechanischen Anschlag 11 anstößt, während ein weiterer den Drehwinkel ϕ anzeigender Zeiger 10, welcher üblicherweise aus einem transparenten Kunststoff gefertigt ist, ebenfalls auf der Welle 20 befestigt wird. Dadurch ist die störende hohe Elastizität des den Drehwinkel ϕ anzeigenden Zeigers 10 durch die geringe Elastizität des ersten Zeigers 10 ersetzt, was eine stabile Endposition mit einem geringeren Zeigermoment M₁₀ ergibt.

Alternativ zu den oben beschriebenen Verfahren können auch andere Verfahrenstypen eingesetzt werden um ein Abspringen des Zeigers 10 vom Anschlag 11 zu verringern, so beispielsweise ein Verringern der Zeigergeschwindigkeit beim Anfahren an den Anschlag 11.

## Patentansprüche

1. Verfahren zur Verringerung der Stärke einer unkontrollierten Zeigerbewegung eines von einem Schrittmotor (14) über dessen Rotor (12) drehend angetriebenen, an einem mechanischen Anschlag (11) anliegenden Zeigers (10) beim Abschalten des Schrittmotors (14), **dadurch gekennzeichnet, dass** vor dem Abschalten des Schrittmotors (14) Maßnahmen, die ein Abspringen des Zeigers (10) von dem Anschlag (11) verringern, derart getroffen werden, dass die Feldstärke des auf den Rotor (12) des Schrittmotors (14) wirkenden Magnetfeldes des Schrittmotors (14) auf einen niedrigeren Wert abgesenkt wird oder dass der Zeiger (10) vor dem Abschalten um einen vorgegebenen Ausgleichsdrehwinkel (Δϕ) vom Anschlag (11) wegbewegt wird oder dass der Schrittmotor (14) nach dem Abschalten wenigstens einmal nach einer vorgegebenen Abschaltzeitspanne (tₐ₁, tₐ₂, tₐ₃) für eine vorgegebene Einschaltzeitspanne (tₑ₁, tₑ₂, tₑ₃) wieder eingeschaltet wird.

2. Verfahren nach Anspruch 1, **dadurch gekennzeichnet, dass** die Feldstärke kontinuierlich auf den niedrigeren Wert abgesenkt wird.

3. Verfahren nach Anspruch 1, **dadurch gekennzeichnet, dass** die Feldstärke in diskreten Stufen auf den niedrigeren Wert abgesenkt wird.

4. Verfahren nach einem der vorhergehenden Ansprüche, **dadurch gekennzeichnet, dass** die Feldstärke langsamer abgesenkt wird, als die Dauer der mechanischen Zeitkonstante des Schrittmotors (14).

5. Verfahren nach einem der vorhergehenden Ansprüche, **dadurch gekennzeichnet, dass** die Feldstärke abgesenkt wird, indem die Ansteuerspannung der Ansteuerwicklungen (15) des Schrittmotors (14) verringert wird.

6. Verfahren nach Anspruch 5, **dadurch gekennzeichnet, dass** die Ansteuerspannung der Ansteuerwicklungen (15) des Schrittmotors (15) verringert wird, indem die Pulsweite eines den Ansteuerwicklungen (15) vorgeschalteten Pulsweitenmodulators (2) vermindert wird.

7. Verfahren nach Anspruch 5 oder 6, **dadurch gekennzeichnet, dass** die Ansteuerspannung der Ansteuerwicklungen (15) des Schrittmotors (15) verringert wird, indem der Elementwert wenigstens einer steuerbaren Impedanz (R_{V}) einer den Ansteuerwicklungen (15) vorgeschalteten Impedanzschaltung (16) verändert werden.

8. Verfahren nach einem der vorhergehenden Ansprüche, **dadurch gekennzeichnet, dass** die Feldstärke abgesenkt wird, indem die Versorgungsspannung (U_{A}) eines dem Schrittmotor (14) vorgeschalteten Schrittmotortreibers (3) verringert wird.

9. Verfahren nach einem der vorhergehenden Ansprüche, **dadurch gekennzeichnet, dass** der Wert des Ausgleichsdrehwinkels (Δϕ) aus einem Speichermedium (19) ausgelesen wird.

10. Verfahren nach einem der vorhergehenden Ansprüche, **dadurch gekennzeichnet, dass** eine niedrige Drehgeschwindigkeit für die Wegbewegung des Zeigers (10) um den Ausgleichsdrehwinkel (Δϕ) gewählt wird.

11. Verfahren nach einem der vorhergehenden Ansprüche, **dadurch gekennzeichnet, dass** während oder nach dem Wegbewegen des Zeigers (10) um den Ausgleichsdrehwinkel (Δ ϕ) und vor dem Abschalten des Schrittmotors (14) die Feldstärke des Magnetfeldes des Schrittmotors (14) auf einen niedrigeren Wert abgesenkt wird.

12. Verfahren nach einem der vorhergehenden Ansprüche, **dadurch gekennzeichnet, dass** der Schrittmotor (14) mehrfach ein- und wieder ausgeschaltet wird, wobei die Abschaltzeitspannen (tₐ₁, tₐ₂, tₐ₃) ansteigen.

13. Verfahren nach Anspruch 12, **dadurch gekennzeichnet, dass** die kürzeste Abschaltzeitspanne (tₐ₁, tₐ₂, tₐ₃) kleiner gewählt wird, als die kürzestmögliche Zeitspanne, in der sich der Rotor (12) des Schrittmotors (14) um eine ganze Umdrehung weiterbewegt, und dass die längste Abschaltzeitspanne (tₐ₁, tₐ₂, tₐ₃) kleiner gewählt wird, als die längstmögliche Zeitspanne, in der sich der Rotor (12) des Schrittmotors (14) um eine ganze Umdrehung weiterbewegt.

14. Verfahren nach Anspruch 13, **dadurch gekennzeichnet, dass** die Summe aus der Einschaltzeitspanne (tₑ₁, tₑ₂, tₑ₃) und der vorhergehenden Abschaltzeitspanne (tₐ₁, tₐ₂, tₐ₃) größer gewählt wird als die Zeitspanne, in der sich der Rotor (12) des Schrittmotors (14) in diesem Zeitraum um eine ganze Umdrehung weiterbewegt.

## Claims

1. Method for reducing the magnitude of an uncontrolled instrument-pointer movement of an instrument-pointer (10) which is driven in rotation by a stepping motor (14) via its rotor (12) and bears against a mechanical stop (11), when the stepping motor (14) is switched off, **characterized in that**, before the stepping motor (14) is switched off, measures which reduce the rebounding of the instrument-pointer (10) from the stop (11) are taken such that the field strength of the magnetic field of the stepping motor (14) which acts on the rotor (12) of the stepping motor (14) is reduced to a lower value, or **in that**, before the switching off occurs, the instrument-pointer (10) is moved away from the stop (11) by a predefined compensation rotational angle (Δϕ), or **in that**, after the switching off occurs, the stepping motor (14) is switched on again at least once for a predefined switch-on time period (tₑ₁, tₑ2, tₑ₃) after a predefined switching-off time period (tₐ₁, tₐ₂, tₐ₃).

2. Method according to Claim 1, **characterized in that** the field strength is continuously reduced to a relatively low value.

3. Method according to Claim 1, **characterized in that** the field strength is reduced to the relatively low value in discrete steps.

4. Method according to one of the preceding claims, **characterized in that** the field strength is lowered more slowly than the duration of the mechanical time constant of the stepping motor (14).

5. Method according to one of the preceding claims, **characterized in that** the field strength is lowered by reducing the drive voltage of the drive windings (15) of the stepping motor (14).

6. Method according to Claim 5, **characterized in that** the drive voltage of the drive windings (15) of the stepping motor (14) is reduced by decreasing the pulse width of a pulse width modulator (2) which is connected upstream of the drive windings (15).

7. Method according to Claim 5 or 6, **characterized in that** the drive voltage of the drive windings (15) of the stepping motor (14) is reduced by changing the element value of at least one controllable resistor (R_{V}) of an impedance circuit (16) which is connected upstream of the drive windings (15).

8. Method according to one of the preceding claims, **characterized in that** the field strength is lowered by reducing the supply voltage (U_{A}) of a stepping motor driver (3) which is connected upstream of the stepping motor (14).

9. Method according to one of the preceding claims, **characterized in that** the value of the equalizing rotational angle (Δϕ) is read out from a memory medium (19).

10. Method according to one of the preceding claims, **characterized in that** a low rotational speed is selected for the movement of the instrument-pointer (10) away by the compensation rotational angle (Δϕ).

11. Method according to one of the preceding claims, **characterized in that** the field strength of the magnetic field of the stepping motor (14) is lowered to a relatively low value during or after the movement of the instrument-pointer (10) away by the compensation rotational angle (Δϕ) and before the stepping motor (14) is switched off.

12. Method according to one of the preceding claims, **characterized in that** the stepping motor (14) is switched on and off repeatedly, the switch-off time periods (tₐ₁, tₐ₂, tₐ₃) increasing.

13. Method according to Claim 12, **characterized in that** the shortest switch-off time period (tₐ₁, tₐ₂, tₐ₃) is selected to be shorter than the shortest possible time period in which the rotor (12) of the stepping motor (14) moves on by one complete revolution, and **in that** the longest switch-off time period (tₐ₁, tₐ₂, tₐ₃) is selected to be shorter than the longest possible time period in which the rotor (12) of the stepping motor (14) moves on by one complete revolution.

14. Method according to Claim 13, **characterized in that** the sum of the switch-on time period (tₑ₁, tₑ₂, tₑ₃) and of the preceding switch-off time period (tₐ₁, tₐ₂, tₐ₃) is selected to be longer than the time period in which the rotor (12) of the stepping motor (14) moves on by one complete revolution in this time period.

## Revendications

1. Procédé pour réduire l'intensité du mouvement incontrôlé d'une aiguille (10) entraînée en rotation par un moteur pas à pas (10) par l'intermédiaire de son rotor (12), et s'appliquant contre une butée mécanique (11) lors de la coupure du moteur pas à pas (14),
**caractérisé en ce qu'**
avant de couper le moteur pas à pas (14) on prend des mesures qui réduisent le rebond de l'aiguille (10) de la butée (11) en diminuant l'intensité du champ magnétique du moteur pas à pas (14) agissant sur le rotor (12) du moteur (14) à une valeur plus faible, ou
avant la coupure on écarte l'aiguille (10) d'un angle de rotation de compensation (Δϕ) prédéfini par rapport à la butée (11), ou
après la coupure on branche de nouveau le moteur pas à pas (14) au moins une fois après une durée de coupure prédéfinie (tₐ₁, tₐ₂, tₐ₃) pour une durée de branchement prédéfinie (tₑ₁, tₑ₂, tₑ₃).

2. Procédé selon la revendication 1,
**caractérisé en ce qu'**
on diminue en continu l'intensité du champ jusqu'à la valeur basse.

3. Procédé selon la revendication 1,
**caractérisé en ce qu'**
on abaisse l'intensité du champ en étapes discrètes pour atteindre la valeur basse.

4. Procédé selon l'une quelconque des revendications précédentes,
**caractérisé en ce qu'**
on abaisse l'intensité du champ plus lentement que la durée de la constante de temps mécanique du moteur pas à pas (14).

5. Procédé selon l'une quelconque des revendications précédentes,
**caractérisé en ce qu'**
on abaisse l'intensité du champ en diminuant la tension de commande appliquée aux enroulements de commande (15) du moteur pas à pas (14).

6. Procédé selon la revendication 5,
**caractérisé en ce qu'**
on diminue la tension de commande des enroulements de commande (15) du moteur pas à pas (14) en diminuant la largeur d'impulsion du modulateur de largeur d'impulsion (2) attaquant les enroulements de commande (15).

7. Procédé selon les revendications 5 ou 6,
**caractérisé en ce qu'**
on diminue la tension de commande de l'enroulement de commande (15) du moteur pas à pas (14) en modifiant la valeur élémentaire d'au moins une impédance commandée (R_{V}) d'un circuit d'impédance (16) en amont des enroulements de commande (15).

8. Procédé selon l'une quelconque des revendications précédentes,
**caractérisé en ce qu'**
on abaisse l'intensité du champ en diminuant la tension d'alimentation (U_{A}) d'un pilote de moteur pas à pas (3) en amont du moteur pas à pas (14).

9. Procédé selon l'une quelconque des revendications précédentes,
**caractérisé en ce qu'**
on extrait la valeur (Δϕ) de l'angle de rotation de compensation d'une mémoire (19).

10. Procédé selon l'une quelconque des revendications précédentes,
**caractérisé en ce qu'**
on sélectionne une vitesse de rotation faible pour le mouvement de l'aiguille (10) autour de l'angle de rotation de compensation (Δϕ).

11. Procédé selon l'une quelconque des revendications précédentes,
**caractérisé en ce que**
pendant ou après que l'aiguille (10) s'écarte de l'angle de rotation de compensation (Δϕ) et avant la coupure du moteur pas à pas (14) on diminue l'intensité du champ magnétique du moteur pas à pas (14) à une valeur plus faible.

12. Procédé selon l'une quelconque des revendications précédentes,
**caractérisé en ce qu'**
on coupe et on rebranche plusieurs fois le moteur pas à pas (14), les durées de coupure (tₐ₁, tₐ₂, tₐ₃) étant croissantes.

13. Procédé selon la revendication 12,
**caractérisé en ce que**
la durée de coupure la plus courte (tₐ₁, tₐ₂, tₐ₃) est choisie inférieure à la durée la plus courte possible au cours de laquelle le rotor (12) du moteur pas à pas (14) effectue une rotation complète et la durée de coupure (tₐ₁, tₐ₂, tₐ₃) la plus longue est choisie inférieure à la durée la plus longue au cours de laquelle le rotor (12) du moteur pas à pas (14) tourne d'un tour complet.

14. Procédé selon la revendication 13,
**caractérisé en ce que**
la somme des durées de coupure (tₑ₁, tₑ₂, tₑ₃) et des durées de branchement (tₐ₁, tₐ₂, tₐ₃) est choisie supérieure à la durée au cours de laquelle le rotor (12) du moteur pas à pas (14) effectue une rotation complète dans cette période.
